# EUROPEAN PATENT APPLICATION

(11) **EP 1 826 878 A2**
(43) Date of publication of application: **29.08.2007**
(21) Application number: 07003185.1
(22) Date of filing: 15.02.2007
(51) Int. Cl.: H01R 13/658, H01R 12/14

(54) **Connector sheet and portable electronic apparatus**

(30) Priority: 22.02.2006 JP 2006046047
(71) Applicant: POLYMATECH CO., LTD., Tokyo (JP)
(72) Inventor: Konno, Hideaki, Tokyo (JP)
(74) Representative: Lorenz, Markus

(57) **Abstract**

Provided is a connector sheet (1) exhibiting requisite conduction property for removal of electromagnetic wave noise and static electricity, allowing ground connection between a metal portion of a casing (10) and a circuit board (8) through a simple mounting operation, and capable of meeting requirement for a reduction in electronic apparatus size, and a portable electronic apparatus equipped with the same.

The connector sheet (1) is conductively connected to a metal casing (10) and a ground-connecting portion (12) of a circuit board (8) through a conducting portion (5) of a connector portion (2 and 3) in which conductive particles are serially oriented. Further, the connector portion (2 and 3) and a resin sheet (4) are integrated with each other.

## Description

### BACKGROUND OF THE INVENTION

### 1. Field of the Invention

The present invention relates to a connector sheet for ground-connecting a metal portion of a casing of an electronic apparatus of various types, such as a mobile phone, a portable music player, a personal digital assistant, a digital camera, or a vehicle-mounted apparatus, to a built-in circuit board in the casing, and to a portable electronic apparatus equipped with such a connector sheet.

### 2. Description of the Related Art

In an electronic apparatus of various types, such as a mobile phone or a portable music player, there is increasingly used, as a material of the casing, a metal material, which exhibits higher mechanical strength than a thermoplastic hard resin and helps to realize a design adding a quality appearance to the apparatus. In particular, due to their light weight, light metal alloys, such as aluminum alloys and magnesium alloys, are often utilized for the casings of portable electronic apparatuses. In some cases, the entire casing is formed of a metal material, and, in other cases, a part of the casing is formed of a metal material.

When thus using a metal material as the material of the casing, it is necessary to effect ground connection between the metal portion of the casing and a built-in circuit board in the casing. Due to an antenna effect of the metal portion, the metal portion will collect electromagnetic wave noise; if this electromagnetic wave noise is dispersed within the electronic apparatus, there is a fear of the signal processing of the circuit board being adversely affected. Further, if static electricity with which the operator has been charged is discharged onto the circuit board through the metal portion, there is a fear of the signal processing of the circuit board being adversely affected as in the case of electromagnetic wave noise.

There are conventionally known three connecting members for effecting ground connection between the metal portion of the casing and the circuit board. The first connecting member, which is disclosed in JP 2000-4093 A, is a sponge with a conductive cloth, which is obtained by winding in a cylindrical fashion a conductive cloth formed of a woven fabric or a knitted fabric of conductive thread around an outer peripheral surface of a flexible core material such as a sponge. The second connecting member is a grounding spring formed of a metal piece, as disclosed in JP 2003-347755 A. The third connecting member formed, as disclosed in JP 2003-347755 A, of a columnar conductive silicone rubber which is obtained through overall, uniform dispersion of a conductive filler, such as silver particles.

These connecting members, however, involve the following problems. The first connecting member, that is, the sponge with a conductive cloth, is held while compressed by the metal portion of the casing and the circuit board. However, it is rather difficult to accurately mount such a small connecting member as the sponge with a conductive cloth at a predetermined position and to hold the small connecting member in a compressed state by the metal portion of the casing and the circuit board. Further, the conducting direction of the sponge with a conductive cloth is the direction in which the conductive cloth is wound around the core material in a cylindrical fashion, and not the direction in which the sponge is compressed by the metal portion and the circuit board. Thus, it is hardly to be regarded as a member endowed with a sufficient conduction property for the removal of electromagnetic noise and static electricity as mentioned above. Its conduction property might be improved by enlarging the area of the conductive cloth. However, that would make it impossible to meet the requirement for a reduction in the size of the electronic apparatus. That is, there is a fear of such a sponge with a large conductive cloth coming into contact with wiring and electronic components of the circuit board, which inherently need no conductive contact. Such unnecessary conductive contact might be avoided by attaching an insulating tape to the circuit board and the conductive cloth. However, that would involve an additional difficult operation of attaching the insulating tape; further, it would make it impossible to reduce the size of the sponge with a conductive cloth. In this way, the first connecting member, that is, the sponge with a conductive cloth, has problems in terms of mounting workability, conduction property, and adaptability to a reduction in the size of the electronic apparatus.

The second connecting member, that is, the grounding spring, is held in a compressed state by the metal portion of the casing and the circuit board like the sponge with a conductive cloth. Since the grounding spring is also a small component, the grounding spring involves a difficult mounting operation as in the case of the sponge with a conductive cloth as described above. Further, in the grounding spring, it is common practice to hold a hard contact portion formed of a metal material in point contact with the metal portion or the ground-connecting portion of the circuit board. Thus, it does not always provide a sufficient conduction property for the removal of electromagnetic wave noise and static electricity mentioned above. In this way, the second connecting member, that is, the grounding spring, has problems in terms of mounting workability and conduction property.

The third connecting member, that is, the conductive silicone rubber, is also held in a compressed state by the metal portion of the casing and the circuit board. Since the conductive silicone rubber is also a small component, the conductive silicone rubber involves a difficult mounting operation like the sponge with a conductive cloth and the grounding spring as described above. Further, to remove the electromagnetic wave noise and static electricity mentioned above, it is necessary to attain a low resistance value of 1 Ω or less. For this purpose, it is necessary to effect overall, uniform dispersion of a large amount of conductive filler in the silicone rubber constituting a base material. However, uniform dispersion of a large amount of conductive filler results in the silicone rubber becoming hard, fragile, and subject to chipping. Further, an increase in cost is involved. Thus, it is rather difficult to realize the requisite conduction property for the removal of electromagnetic wave noise and static electricity. In this way, the third connecting member, that is, the conductive silicone rubber, involves problems in terms of mounting workability and conduction property.

### SUMMARY OF THE INVENTION

The present invention has been made in view of the above-mentioned problems in the prior art. It is accordingly an object of the present invention to provide a novel connector sheet exhibiting requisite conduction property for the removal of electromagnetic wave noise and static electricity and allowing ground connection between a metal portion of a casing and a circuit board through a simple mounting operation, and a portable electronic apparatus equipped with such a connector sheet. It is another object of the present invention to provide a novel connector sheet which helps to meet the requirement for a reduction in the size of electronic apparatuses, and a portable electronic apparatus equipped with such a connector sheet.

In order to achieve the above-mentioned objects, the present invention has the following structure. According to the present invention, there is provided a connector sheet for effecting electrical connection between a metal portion constituting a casing of an electronic apparatus and a ground-connecting portion of a circuit board contained in the casing, the connector sheet including: an electrically insulating sheet portion mounted to the circuit board so that the electrically insulating sheet portion covers the circuit board which is opposed to the metal portion; and a connector portion which is integrally provided with a conducting portion which is arranged at a position in the sheet portion, where the metal portion and the ground-connecting portion are opposed to each other, the conducting portion having one end in contact with the metal portion and another end in contact with the ground-connecting portion.

In the present invention, the conducting portion of the connector portion is in contact with the metal portion of the casing and the ground-connecting portion of the circuit board to effect electrical connection therebetween. Thus, it is possible to prevent electromagnetic wave noise from being collected in the metal portion and to prevent electromagnetic wave noise from being dispersed from the metal portion. Further, it is possible to prevent the metal portion from being charged with static electricity, making it also possible to prevent static electricity from being discharged from the metal portion.

In the present invention, this connector portion is provided in a part of the sheet portion. That is, the sheet portion is mounted to the circuit board so as to partially or totally cover the circuit board, which is opposed to the metal portion of the casing, and the connector portion is provided in the portion of the sheet portion, where the metal portion and the ground-connecting portion are opposed to each other. Thus, according to the present invention, the mounting operation can be effected by a sheet portion larger than the connector portion. Thus, unlike the above-mentioned prior-art techniques, the present invention involves no need to singly mount the small connector portion alone, thus facilitating the mounting operation.

Further, the connector portion is provided in the portion of the sheet portion where the metal portion and the ground-connecting portion are opposed to each other. Thus, by mounting the sheet portion to the circuit board as described above, it is possible to effect positioning accurately on the small connector portion with respect to the ground-connecting portion of the circuit board.

Further, since it is possible to effect positioning accurately on the ground-connecting portion of the circuit board, there is no need to design the conducting portion and the connector portion in an extra-large size taking into account allowance for positional deviation. Thus, the connector sheet is suitable for use in an electronic apparatus in which wiring and circuit elements are mounted on a circuit board at high density, in particular, a portable electronic apparatus, and is also capable of meeting the requirement for a reduction in the size of such apparatuses.

The present invention can provide a connector sheet in which the sheet portion has a plurality of mounting portions for fixing to the circuit board. The sheet portion is fixed in position not by a single mounting portion but by a plurality of mounting portions. Thus, in the present invention, the sheet portion can be positioned at the accurate mounting position, and it is possible to maintain that mounting state.

The present invention can provide a connector sheet in which the connector portion is positioned between at least two mounting portions. With the construction in which the connector portion is positioned between at least one mounting portion and another mounting portion, the mounting position for the connector portion is restricted by the two mounting portions. Thus, in the present invention, it is possible to prevent deviation of the mounting position for the connector portion and to maintain that mounting state.

The present invention can provide a connector sheet in which the sheet portion has at least one mounting portion for fixing the connector sheet to the circuit board and an adhesive portion glued to the circuit board. In the present invention, the adhesive portion is brought into intimate contact with the circuit board even when there is only one mounting portion, so it is possible to accurately maintain the mounting position for the sheet portion and the connector portion.

In this case, the adhesive portion may be formed by an adhesive applied to the surface of the sheet portion opposed to the circuit board, or by a double-faced adhesive tape attached to the opposing surface of the sheet portion. It is also possible for the sheet portion itself to contain an additive developing adhesiveness. When the adhesive portion is formed as a soft and thick adhesive layer, the adhesive portion can come into soft contact with the circuit elements and wiring of the circuit board and the sheet portion, functioning as a cushion for protecting them.

More specifically, the "mounting portion" of the present invention described above can be formed so as to extend through in the sheet portion as a screw insertion hole for fixing the circuit board to the casing. In this construction, the sheet portion is electrically insulating, so the sheet portion can be utilized as a substitute for a washer for receiving the head portion of a screw. Further, the mounting portion may be formed as a projection protruding from the surface of the sheet portion opposed to the circuit board to be engaged with the circuit board. In this case, it is possible to adopt a mounting structure in which a hole to be engaged with the projection is provided in the circuit board. With this construction, the connector sheet can be easily mounted to the circuit board by a one-touch mounting operation in which the projection is forced into the hole.

The present invention can provide a connector sheet in which the ground-connecting portion of the circuit board protrudes from the board surface and in which the connector portion has an engagement recess to be engaged with the ground-connecting portion. The engagement recess of the connector portion is engaged with the ground-connecting portion in the form of a projection. Thus, in the present invention, the operation of mounting the connector portion to the ground-connecting portion can be easily conducted. Further, it is possible to prevent positional deviation and detachment between the connector portion and the ground-connecting portion, making it possible to maintain a stable ground connection.

The present invention can provide a connector sheet in which the sheet portion is flexible enough to conform to a change in the height of the circuit board, whose height changes according to the presence/absence of the circuit elements. In the present invention, due to the flexibility of the sheet portion, even when there is a change in the height of the circuit board according to the presence/absence of the circuit elements, it is possible to reliably mount the sheet portion to the circuit board according to the change in height.

The present invention can provide a connector sheet in which the sheet portion has a cutout portion allowing opening of the sheet portion in the shearing direction in conformity with a change in the height of the circuit board, whose height changes according to the presence/absence of the circuit elements. Since the cutout portion of the sheet portion can be opened, it is possible to absorb a change in the height of the circuit board according to the presence/absence of circuit elements, etc. Thus, in the present invention, it is possible to avoid forcible expansion or deformation of the sheet portion due to a change in the height of the circuit board. Thus, it is possible to fix the sheet portion to the circuit board without any forcing, and to mount the connector portion at the accurate mounting position, and that mounting state can be maintained.

The present invention can provide a connector sheet in which the connector portion is formed so as to pass through the sheet portion in the thickness direction and protrude from both sides thereof. In mounting the connector sheet of the present invention, when the sheet portion and the connector portion are flatly continuous with each other, it is necessary to apply a compression load not only to the connector portion but also to the sheet portion in order to realize a stable conductive connection of the connector portion. Then, a repulsive load constantly acts on the casing and the circuit board over a wide range, and there is a fear of the casing or the circuit board undergoing deformation. In the present invention, however, it is only necessary to apply a load to the connector portion protruding from the sheet portion. Thus, it is possible to realize a stable conductive connection of the connector portion with less compression load, making it possible to prevent such deformation as mentioned above.

The present invention can provide a connector sheet in which the connector portion extends through the sheet portion in the thickness direction and protrudes from one side thereof. In the present invention, the connector portion protrudes from one side of the sheet portion, with no sheet portion existing at any midpoint in the height direction of the connector portion. Thus, when the connector portion is held in a compressed state by the metal portion and the circuit board to realize a stable conductive connection, the side surface of the connector portion easily undergoes outward swelling and deformation, making it possible to diminish the compression load applied to realize a stable conductive connection. Thus, it is possible to diminish the repulsive load of the connector portion acting on the casing or the circuit board, making it possible to prevent their deformation.

Further, according to the present invention, there is provided a portable electronic apparatus, including: a casing having a metal portion; a circuit board containing the casing; and the connector sheet according to the present invention effecting electrical connection between the metal portion of the casing and a ground-connecting portion of the circuit board.

According to the present invention, it is possible to reliably remove electromagnetic wave noise and static electricity by the connector portion of the connector sheet, making it possible to achieve an improvement in terms of operational reliability. In the step of assembling the portable electronic apparatus, the connector sheet can be easily mounted through the intermediation of the sheet portion. This helps to achieve an improvement in terms of productivity. Further, the connector portion can be accurately positioned to be mounted and that mounting state can be maintained. Thus, even when, as a result of achievement of greater functionality, the wiring and circuit elements are mounted at higher density and there is a demand for a reduction in the size of the apparatus as a whole, it is possible to design the connector sheet in conformity therewith. Specifically, in the present invention, the portable electronic apparatus may be structured as any type of portable apparatus, such as a mobile phone, a PDA, a portable music player, a portable motion video player, a portable personal computer, or a remote controller.

The present invention can provide a connector sheet in which the connector portion has a conducting portion and an insulating portion surrounding the outer periphery of the conducting portion to retain the same and formed of a rubber-like elastic material. When the connector portion is held in a compressed state by the metal portion of the casing and the ground-connecting portion of the circuit board, the connector portion undergoes outward swelling deformation due to the compression. Then, there is a fear of the conducting portion of the connector portion coming into electrical contact with the circuit elements and wiring mounted on the circuit board at high density. In the present invention, however, the insulating portion formed of a rubber-like elastic material surrounds the outer periphery of the conducting portion. Thus, it is possible to prevent the conducting portion of the connector portion from coming into electrical contact with the peripheral circuit elements and wiring.

The present invention can provide a connector sheet in which the conducting portion of the connector portion is in the form of a column in which conductive particles are serially magnetic-field-oriented in the thickness direction of the sheet portion. Thus, it is possible to realize a soft conducting portion which, while exhibiting a satisfactory conduction property, contains a smaller amount of conductive particles as compared with the conductive silicone rubber of the prior-art technique, in which a large amount of conductive filler is dispersed uniformly.

In the connector sheet and the portable electronic apparatus of the present invention, even when there is a metal portion in the casing, it is possible to prevent collection of electromagnetic wave noise in the metal portion, and to prevent the metal portion from being charged with static electricity. Thus, it is possible to realize an electronic apparatus that is not easily to be influenced by electromagnetic wave noise and static electricity and relatively free from a malfunction due to that influence.

In the connector sheet and the portable electronic apparatus of the present invention, the small connector portion is integrated with the large sheet portion, and can be easily mounted on the circuit board by virtue of the sheet portion. Thus, it is possible to achieve a substantial enhancement in mounting workability and to achieve an improvement in terms of the productivity of the electronic apparatus.

In the connector sheet and the portable electronic apparatus of the present invention, positioning is accurately effected on the connector portion when mounting the same, and it is possible to maintain that accurate mounting state. Thus, even in the case of a circuit board on which wiring, circuit elements, solder for fixing the circuit elements, etc. are mounted at high density, there is no fear of the connection portion coming into contact with them. Thus, the connector sheet of the present invention can meet the requirement for a reduction in the size and thickness of electronic apparatuses, and is suitable for use in portable electronic apparatuses, in particular, a mobile phone, a portable music player, etc.

The above description of the present invention should not be construed restrictively; the advantages, features, and uses of the present invention will become more apparent from the following description given with reference to the accompanying drawings. Further, it should be understood that all appropriate modifications made without departing from the gist of the present invention are covered by the scope of the present invention.

### BRIEF DESCRIPTION OF THE DRAWINGS

In the accompanying drawings:

Fig. 1 is an explanatory view of an electronic apparatus equipped with a connector sheet according to a first embodiment;

Fig. 2 is a sectional view taken along the line II-II of Fig. 1;

Fig. 3 is an explanatory view of a sheet portion used in the connector sheet of the first embodiment;

Fig. 4 is an explanatory view of an electronic apparatus equipped with a connector sheet according to a second embodiment;

Fig. 5 is a sectional view taken along the line V-V of Fig. 4;

Fig. 6 is an explanatory view of an electronic apparatus equipped with a connector sheet according to a third embodiment;

Fig. 7 is a sectional view taken along the line VII-VII of Fig. 6;

Fig. 8 is an explanatory view of an electronic apparatus equipped with a connector sheet according to a fourth embodiment;

Fig. 9 is a sectional view taken along the line IX-IX of Fig. 8;

Fig. 10 is an explanatory view of an electronic apparatus equipped with a connector sheet according to a fifth embodiment;

Fig. 11 is a sectional view taken along the line XI-XI of Fig. 10;

Fig. 12 is an explanatory view of an electronic apparatus equipped with a connector sheet according to a sixth embodiment;

Fig. 13 is a sectional view taken along the line XIII-XIII of Fig. 12; and

Figs. 14A through 14C are enlarged partial views of modifications of a cutout, of which Fig. 14A is an enlarged plan view, Fig. 14B is an enlarged sectional view taken along the line XIV(B)-XIV(B) of Fig. 14A, and Fig. 14C is an enlarged plan view of another modification.

### DESCRIPTION OF THE PREFERRED EMBODIMENTS

In the following, embodiments of the present invention will be described with reference to the drawings. In the drawings, reference symbols are used to indicate portions and components. The components common to the embodiments are indicated by the same reference symbols, and a redundant description thereof will be omitted.

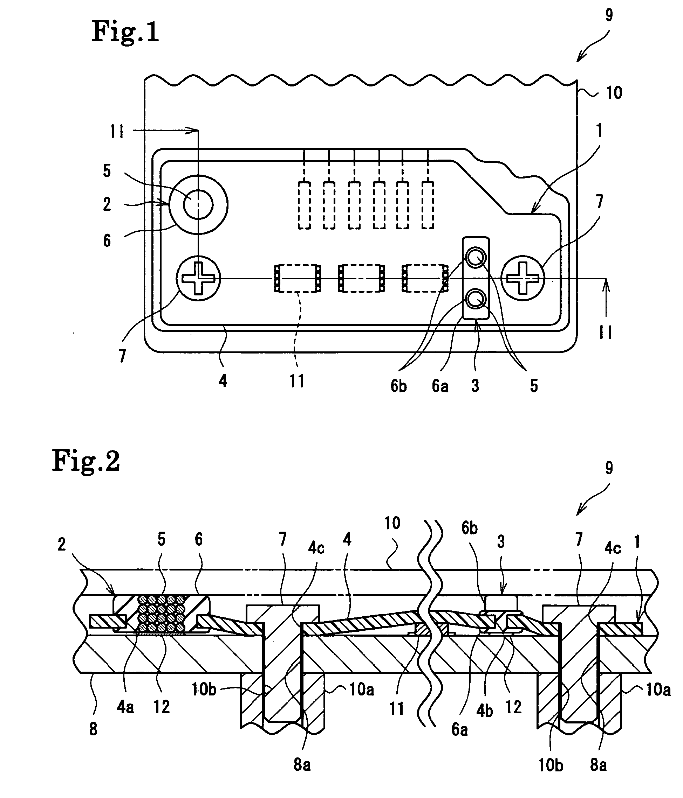

First Embodiment (Figs. 1 through 3): A connector sheet (1) according to a first embodiment is equipped with two connector portions (2 and 3) and a resin sheet (4) as the "sheet portion".

The first connector portion (2) is formed of a rubber-like elastic material such as silicone rubber. The connector portion (2) has a conducting portion (5) and an insulating portion (6). Of those, the conducting portion (5) is situated at the center of the connector portion (2), and is formed as a column in which minute conductive particles having magnetic property are serially oriented in the thickness direction of the connector portion (2) (direction in height along the axis thereof). The insulating portion (6) is formed as a cylinder surrounding the outer periphery of the conducting portion (5). Embedded in the outer peripheral side surface of the insulating portion (6) are a first through-hole (4a) formed in the resin sheet (4) and the peripheral portion thereof (hole edge portion). That is, the connector portion (2) extends through the through-hole (4a) of the resin sheet (4) and protrude from both sides of the resin sheet (4). Thus, the connector portion (2) is firmly integrated with the resin sheet (4) so as to be free from detachment through fixation engagement with the through-hole (4a) of the resin sheet (4) and the peripheral portion thereof.

The second connector portion (3) is also formed of a rubber-like elastic material such as silicone rubber, and has the conducting portion (5) and the insulating portion (6). There are provided two conducting portions (5), both of which are formed as columns in which conductive particles having magnetic properties are serially oriented in the thickness direction of the connector portion (3). The insulating portion (6) has a base portion (6a) formed as a parallelepiped fixed to the resin sheet (4) and cylindrical projections (6b) protruding from the upper surface and the lower surface of the base portion (6a). Embedded in the outer peripheral side surface of the base portion (6a) are a substantially circular second through-hole (4b) extending through the resin sheet (4) and the peripheral portion thereof (hole edge portion). That is, like the connector portion (2) described above, the connector portion (3) extends through the through-hole (4b) of the resin sheet (4), and is firmly integrated with the resin sheet (4) so as to be free from detachment through fixation engagement the through-hole (4b) of the resin sheet (4) and the peripheral portion thereof. The axes of the portions of the projections (6b) protruding on the upper side of the base portion (6a) are matched with the axes of the portions of the same protruding on the lower side thereof. Thus, the above-mentioned two conducting portions (5) are formed so as to extend through the connector portion (3) in the thickness direction along the common axes.

As described below, the connector portions (2 and 3) are both formed by molding. More specifically, the conducting portions (5) are formed by magnetic-field-orienting conductive particles dispersed in liquid silicone rubber in the mold, and then curing is effected to thereby form the connector portions (2 and 3). Thus, microscopically, the conducting portions (5) and the insulating portions (6) are not strictly separated from each other but there exists also in the conducting portions (5) silicone rubber constituting the insulating portions (6). Thus, the connector portions (2 and 3) as a whole can undergo elastic deformation. At the time of mounting to the electronic apparatus, a compression load is applied to them to cause them to undergo elastic deformation, whereby the conductive particles are brought into more intimate contact with each other, making it possible for them to exhibit a satisfactory conduction property.

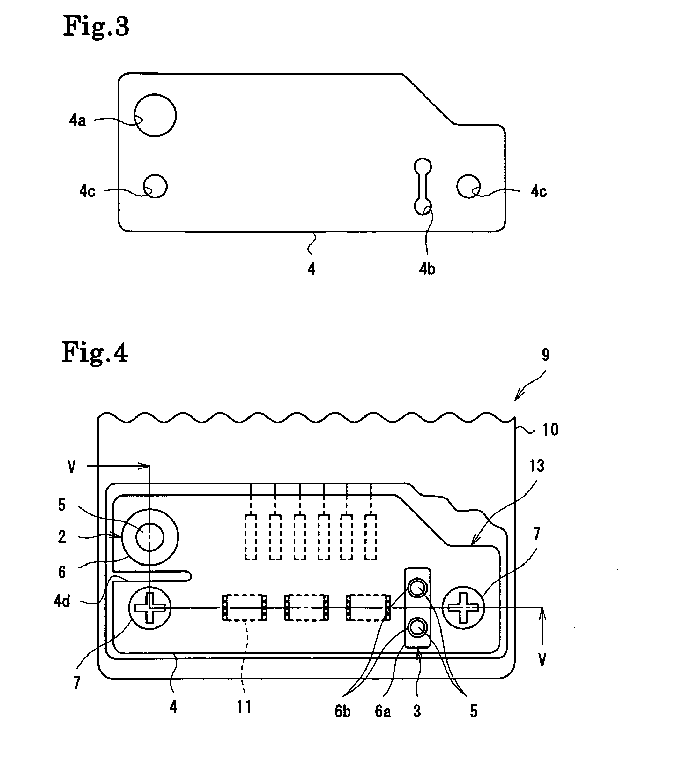

The resin sheet (4) is formed of an insulating film made of a polyethylene terephthalate (PET) resin or the like. The resin sheet (4) exhibits flexibility. The flexibility enables the resin sheet (4) to be deformed in conformity with a difference in height between the board surface of a circuit board (8) and the upper surfaces of circuit elements (11) due to the presence/absence of the circuit elements (11) mounted on the circuit board (8) or a difference in height between the circuit elements (11) differing in height as measured from the board surface. Apart from the first through-hole (4a) and the second through-hole (4b) extending through the resin sheet (4), the resin sheet (4) has two insertion holes (4c) used to fix it to an electronic apparatus (9), such as a portable music player, together with the connector sheet (1) by means of metal screws (7) formed of stainless steel (Fig. 3).

Next, an embodiment of the electronic apparatus (9) as the "portable electronic apparatus" equipped with the connector sheet (1) of the first embodiment will be described. In the electronic apparatus (9), a casing (10) formed of a metal material such as magnesium alloy, contains at least the connector sheet (1) and the circuit board (8).

When in use, the connector sheet (1) is put over the circuit board (8) so as to cover the circuit elements (11) and wiring arranged on the circuit board (8). The circuit board (8) is mounted to the casing (10) by using the metal screws (7). Formed adjacent to the metal screws (7) are ground-connecting portions (12) made of solder connected to the circuit board. When performing the mounting, the insertion holes (4c) of the connector sheet (1) and the insertion holes (8a) of the circuit board (8) are first aligned with each other. Through this alignment, positioning is effected on one end of each conducting portion (5) of the connector sheet (1) with respect to the ground-connecting portion (12) protruding from the board surface. Then, the metal screws (7) are inserted into the insertion holes (4c and 8a) from above the connector sheet (1), and are threadedly engaged with mounting holes (10b) of mounting projections (10a) provided within the casing (10). Finally, the casing (10) is placed in position, whereby the other ends of the conducting portions (5) of the connector sheet (1) are brought into contact in a compressed state with the inner surface of the casing (10) formed of a metal material. As a result, the casing (10) is electrically connected with the ground-connecting portions (12) of the circuit board (8).

Here, the materials of the components of the connector sheet (1) of this embodiment will be described. The following description also applies to the other embodiments described below.

Examples of the "rubber-like elastic material" that can be used to form the connector portions (2 and 3) include silicone rubber, natural rubber, isoprene rubber, butadiene rubber, 1, 2-polybutadiene rubber, styrene/butadiene rubber, nitrile rubber, butyl rubber, ethylene/propylene rubber, and urethane rubber. It is desirable to use silicone rubber, which is particularly superior from the viewpoint of electrical insulation property and environmental characteristics. In order that the conductive particles forming the conducting portions (5) may easily form chains in the rubber-like elastic material, there is used a material which is liquid prior to solidification. In particular, when the viscosity in the liquid state (25°C) ranges from 10 Pa·s to 50 Pa·s, the conductive particles dispersed in the liquid rubber-like elastic material through magnetic-field orientation in the mold can move easily, making it possible to concentrate the conductive particles in the conducting portions (5) so that they may not remain in the insulating portions (6).

Taking into consideration the fact that it is integrally molded through heating of the rubber-like elastic material, the resin sheet (4) may be formed by a resin sheet made of a resin of high heat resistance. For example, PET resin, and polyimide resin, which are superior in dimensional stability, are preferably used.

The "conductive particles" are formed of a magnetic conductive material in the form, for example, of particles, fibers, chips, or fine wires. Specific examples of the conductive particles that can be used include materials obtained by plating, with a magnetic conductor, powders, fine wires, etc. of a metal such as nickel, cobalt, iron, ferrite, an alloy containing much of those metals, gold, silver, platinum, aluminum, copper, iron, palladium, or chromium of high conductivity, or an alloy such as stainless steel, resin, or ceramic, and materials obtained, conversely, by plating magnetic conductors with a good conductor metal. When the average grain size of the conductive particles ranges from approximately 1 µm to 200 µm, it is possible to form a chain state efficiently along the magnetic line of force in the magnetic field applied within the mold.

Next, a method of producing the connector sheet (1) will be described.

First, a mold is prepared. The mold is composed of an upper mold and a lower mold formed of a non-magnetic material such as aluminum or copper. At positions in the upper and lower molds corresponding to the conducting portions (5), there are embedded orientation pins formed of a ferromagnetic material such as iron or magnet. One end of each orientation pin is exposed on the cavity surfaces of the upper and lower molds.

On the other hand, the resin sheet (4) as shown in Fig. 3 is formed by stamping of a resin film. The resin sheet (4) is inserted into the mold in which the orientation pins are embedded, and then liquid silicone rubber, which is the material of the connector portions (2 and 3), is poured into the cavity. This liquid silicone rubber is previously mixed with conductive particles having magnetic property.

Next, a magnetic field is applied from above and below the mold by using a magnet. A parallel magnetic field connecting the orientation pins are formed within the cavity, and the conductive particles in the liquid silicone rubber are linked together in the direction of the magnetic line of force. After this linkage, the upper and lower molds are completely clamped together, and heat treatment is conducted to cure the liquid silicone rubber; then, there is formed the connector sheet (1), in which the connector portions (2 and 3) and the resin sheet (4) are integrated with each other.

Finally, the effects of the connector sheet (1) and the electronic apparatus (9) of this embodiment will be described.

According to the connector sheet (1), the conducting portions (5) of the connector portions (2 and 3) are conductively connected to the casing (10) and the ground-connecting portions (12) of the circuit board (8), so it is possible to prevent accumulation of electromagnetic wave noise in the metal casing (10), making it possible to prevent dispersion of electromagnetic wave noise from the casing (10) to the circuit board (8). Further, it is also possible to prevent the casing (10) from being charged with static electricity, making it possible to prevent discharge of static electricity from the casing (10) to the circuit board (8). Thus, it is possible to prevent a malfunction due to electromagnetic wave noise or static electricity, thus realizing operational reliability and operational stability in the electronic apparatus (9).

Since the connector portions (2 and 3) are integral with the resin sheet (4), which is larger than them, it is possible to conduct the operation of mounting the connector portions (2 and 3) by virtue of the resin sheet (4). Thus, unlike the prior-art techniques, the present invention requires no operation of performing positioning singly on each of the small connector portions (2 and 3), thus facilitating the mounting operation.

Further, since the connector portions (2 and 3) are provided at positions in the resin sheet (4) where the ground-connecting portions (12) are opposed to the casing (10), by mounting the resin sheet (4) to the circuit board (8), it is possible to accurately effect positioning on the connector portions (2 and 3) with respect to the ground-connecting portions (12) of the circuit board (8).

Since the resin sheet (4) is fixed in position at the two insertion holes (4c), the resin sheet (4) does not undergo positional deviation, and it is possible to accurately maintain its mounting position. Further, the resin sheet (4) is fixed to the circuit board (8) at the outer edge side position thereof. Thus, in the state in which it is fixed to the circuit board (8), the resin sheet (4) can be endowed with "tautness". Thus, it is possible to perform positioning accurately on the connector portion (3), making it possible to maintain the connector portion (3) at the proper position. In particular, the connector portion (3) of this embodiment exists between the two insertion holes (4c), where fixation is effected with the metal screws (7). Thus, with the resin sheet (4) being in a "taut" state, the position of the connector portion (3) is restricted by the two insertion holes (4c) constituting the fixing positions, so it is possible to prevent positional deviation, in particular, of the connector portion (3).

In this embodiment, the metal screws (7) are inserted into the insertion holes (4c and 8a) from above the resin sheet (4) to effect fixation to the casing (10), so the resin sheet (4) can also function as an insulating washer receiving the head portions of the metal screws (7). Thus, it is possible to prevent electrical contact between the metal screws (7) and the ground-connecting portions (12) of the circuit board (8) adjacent thereto.

Since the resin sheet (4) has flexibility, even if there is a change in height of the circuit board (8) according to the presence/absence of the circuit elements (11), it is possible to reliably mount the resin sheet (4) in conformity with the change in height.

The connector portions (2 and 3) are formed so as to extend through the resin sheet (4) in the thickness direction and protrude from both sides thereof, so when the connector sheet (1) is incorporated into the electronic apparatus (9) and compressed by the casing (10) and the circuit board (8), a compression load is applied solely to the connector portions (2 and 3). Thus, it is possible to realize a stable conductive connection with less compression load, making it possible to prevent deformation of the casing (10) or the circuit board (8).

Since the connector portions (2 and 3) have the insulating portions (6) surrounding the outer peripheries of the conducting portions (5), even when they are compressed by the casing (10) and the ground-connecting portion (12) of the circuit board (8) to undergo outward swelling deformation, it is possible to prevent the conducting portions (5) of the connector portions (2 and 3) from coming into electrical contact with the metal screws (7), the circuit elements (11), wiring, etc. around the same.

In the conducting portions (5) of the connector portions (2 and 3), the conductive particles are arranged so as to be linked together in the conducting direction, so as compared with the conductive silicone rubber of the prior-art technique in which a large amount of conductive filler is dispersed overall and uniformly, it is possible to achieve a reduction in the content of conductive particles, making it possible to realize soft conducting portions (5).

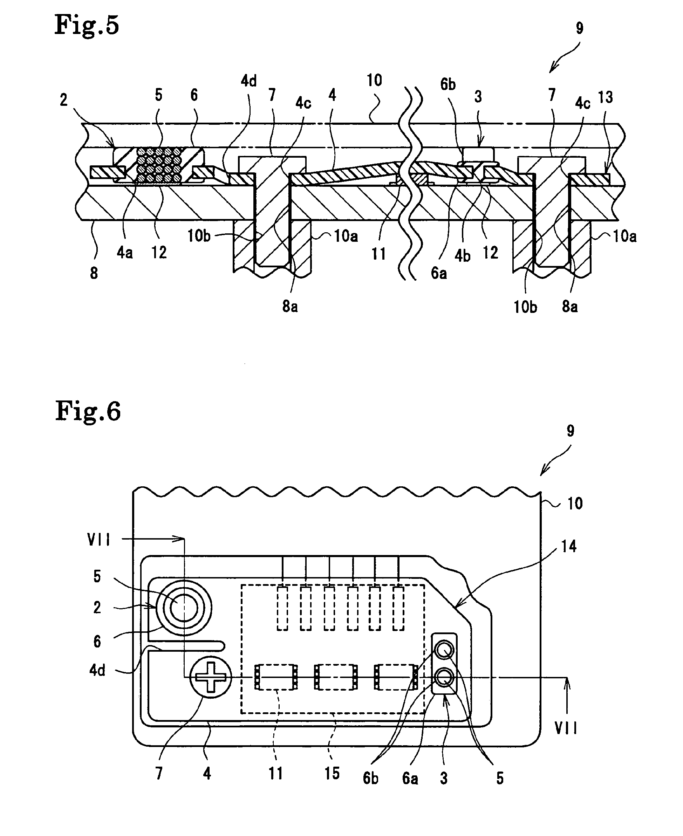

Second Embodiment (Figs. 4 and 5): A connector sheet (13) according to a second embodiment differs from the connector sheet (1) of the first embodiment in the construction of the resin sheet (4). Otherwise, the connector sheet (13) is of the same construction and effects as that of the first embodiment.

The resin sheet (4) has a cutout (4d) between the first through-hole (4a) and the insertion hole (4c) adjacent thereto.

Next, an embodiment of the electronic apparatus (9) equipped with the connector sheet (13) of the second embodiment will be described. The electronic apparatus (9) has the metal casing (10) formed, for example, of a magnesium alloy, and containing at least connector (13) and the circuit board (8). Like the connector sheet (1), the connector sheet (13) is put over the circuit board (8) so as to cover the circuit elements (11) arranged on the circuit board (8). The circuit board (8) is fixed to the casing (10) by the metal screws (7). The ground-connecting portions (12) made of solder are formed adjacent to the metal screws (7).

The connector sheet (13) of the second embodiment can provide the same effects as those of the connector sheet (1) of the first embodiment. Further, the connector sheet (13) provides the following effect.

According to the connector sheet (13), the cutout (4d) opens in the shearing direction, whereby it is possible to absorb a difference in height generated between the periphery of the insertion holes (4c) of the resin sheet (4) in contact with the board surface of the circuit board (8) and the periphery of the through-hole (4a) engaged with the side surface of the connector portion (2). Thus, it is possible to prevent the resin sheet (4) from being forcibly expanded or deformed due to the difference in height generated on the circuit board (8). Thus, it is possible to fix the resin sheet (4) to the circuit board (8) without constraint, and to mount the connector portion (2) at the correct mounting position, maintaining the mounting state.

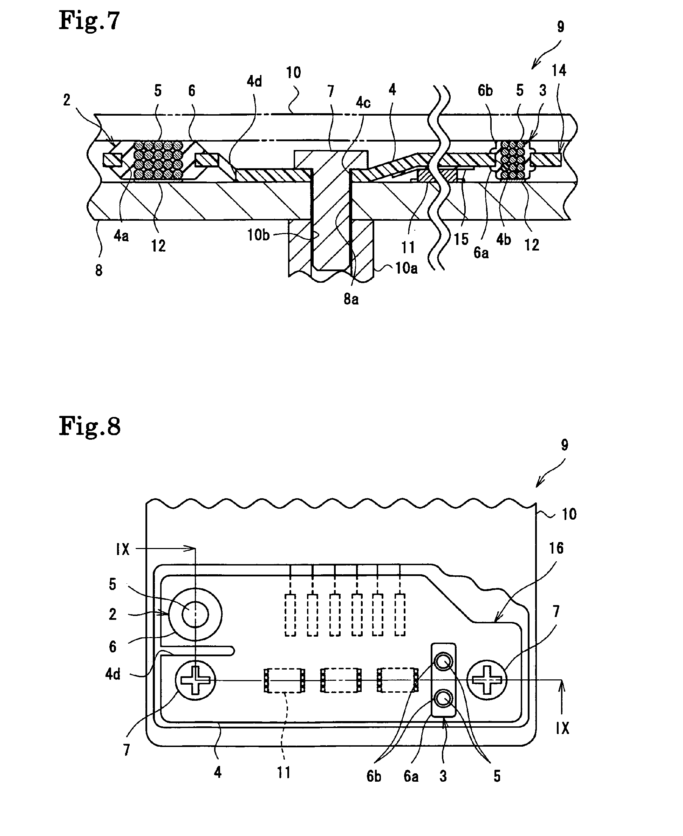

Third Embodiment (Figs. 6 and 7): A connector sheet (14) according to a third embodiment differs from the connector sheet (13) of the second embodiment in the construction of the connector portion (2) and the resin sheet (4). Otherwise, the connector sheet (14) is of the same construction and effects as that of the second embodiment.

In the insulating portion (6) of the connector portion (2), the corner portions of both end surfaces are beveled. That is, the connector portion (2) is formed so as to extend through the through-hole (4a) of the resin sheet (4) and protrude in a truncated-cone-like fashion from both sides of the resin sheet (4).

A single insertion hole (4c) is formed in the resin sheet (4), and an adhesive layer (15) is provided on the surface opposed to the circuit board (8). The adhesive layer (15) can be formed by application of an adhesive, attachment of a double-faced adhesive tape, etc.

Next, an embodiment of the electronic apparatus (9) equipped with the connector sheet (14) of the third embodiment will be described. The electronic apparatus (9) has the metal casing (10) containing at least the connector sheet (14) and the circuit board (8). Like the connector sheet (13), the connector sheet (14) is put over the circuit board (8) so as to cover the circuit elements (11), etc. arranged on the circuit board (8); the ground-connecting portions (12) made of solder are formed adjacent to the metal screws (7). In this embodiment, the connector sheet is fixed to the circuit board (8) by a single metal screw (7).

The connector sheet (14) of the third embodiment provides the same effects as those of the connector sheet (1) of the first embodiment and the connector sheet (13) of the second embodiment; further, the connector sheet (14) provides the following effect.

In the connector sheet (14), the adhesive layer (15) provided on the back side of the flexible resin sheet (4) is glued to the circuit board (8). That is, the adhesive layer (15) is glued to the upper surfaces of the circuit elements (11), the portion of the board surface where there are no circuit elements (11), and the wiring. Thus, even if the number of mounting holes (4c) is reduced to one to reduce the number of metal screws (7) used, the resin sheet (4) does not easily undergo deviation on the circuit board (8) since the adhesive layer (15) is held in intimate contact with the circuit board (8). Thus, it is possible to maintain accurate mounting positions for the resin sheet (4) and the connector portions (2 and 3).

Since the corner portions of both end surfaces of the connector portion (2) are beveled, the contact area of the connector portion (2) held in contact with the casing (10) or the circuit board (8) is reduced, making it possible to diminish the compression load of the connector portion (2). Thus, it is possible to diminish the repulsion load with respect to the casing (10) and the circuit board (8).

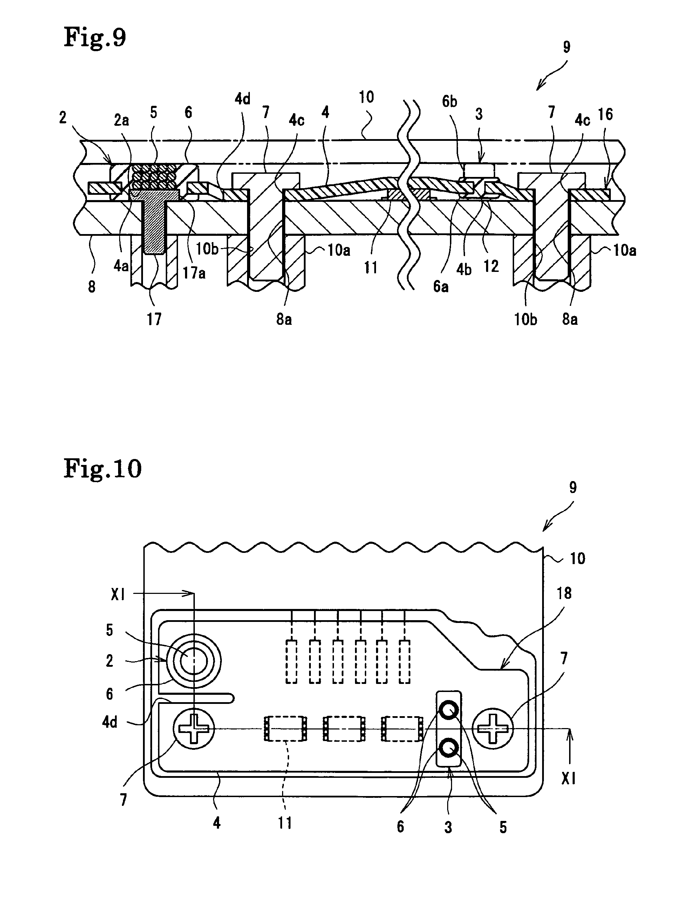

Fourth Embodiment (Figs. 8 and 9): A connector sheet (16) according to a fourth embodiment differs from the connector sheet (13) of the second embodiment in the construction of the first connector portion (2). Otherwise, the connector sheet (16) is of the same construction and effects as that of the second embodiment.

Formed in the first connector (2) is an engagement recess (2a) to be engaged with a head portion (17a) of a stainless steel screw (17) serving as the "ground-connecting portion" protruding from the board surface of the circuit board (8). The lower end of the conducting portion (5) is exposed at the bottom of the engagement recess (2a), so conduction is effected between the head portion (17a) and the casing (10). The insulating portion (6) is formed as a cylinder surrounding the outer periphery of the conducting portion (5) of the insulating portion (6) and forming the side surface of the engagement recess (2a).

Next, an embodiment of the electronic apparatus (9) equipped with the connector sheet (16) of the fourth embodiment will be described. The electronic apparatus (9) has the metal casing (10), which contains at least the connector sheet (16) and the circuit board (8). Like the connector sheet (13), the connector sheet (16) is put over the circuit board (8) so as to cover the circuit elements (11), etc. arranged on the circuit board (8). The circuit board (8) is fixed to the casing (10) by the metal screws (7). In addition to the ground-connecting portions (12) made of solder, there is formed adjacent to the metal screw (7) the ground-connecting portion (12) constituted by the head portion (17a) of the screw (17).

The connector sheet (16) of the fourth embodiment provides the same effects as those of the connector sheet (13) of the second embodiment. Further, the connector sheet (16) provides the following effects.

In the connector sheet (16) of this embodiment, its mounting effected such that the engagement recess (2a) of the first connector portion (2) covers the head portion (17a) of the screw (17) in the form of a projection. The engagement with the head portion (17a) of the screw (17) serves as a means for effecting positioning on the connector portion (2), so the mounting of the connector portion (2) is facilitated. Further, it is possible to prevent positional deviation and detachment of the connector (2) and the head portion (17a) of the screw (17), making it possible to maintain a stable ground connection. Thus, the connector sheet is suitable for use in a portable electronic apparatus, which is subject to external forces such as falling impact or contact impact.

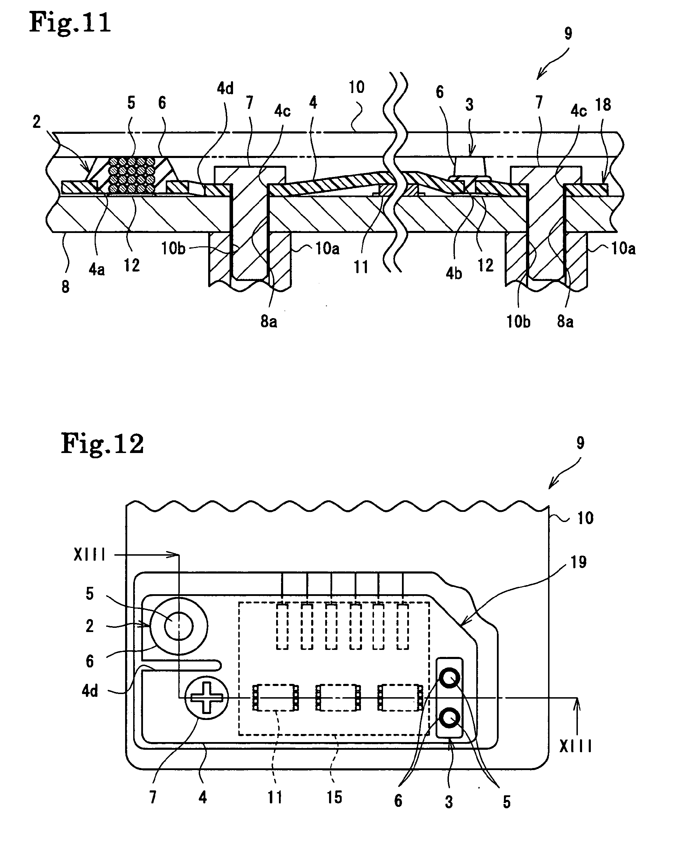

Fifth Embodiment (Figs. 10 and 11): A connector sheet (18) according to a fifth embodiment differs from the connector sheet (13) of the second embodiment in the construction of the first connector portion (2) and the second connector portion (3). Otherwise, the connector sheet (18) is of the same construction and effects as that of the second embodiment.

While they extend through the resin sheet (4), the connector portions (2 and 3) protrude from only one side thereof. The lower ends of the outer peripheral side surfaces of the insulating portions (6) of those connector portions are engaged with the first circular through-hole (4a) or the second circular through-hole (4b) formed in the resin sheet (4) and the peripheral portions thereof. That is, the connector portions (2 and 3) are formed so as to extend through the through-hole (4a) or the through-hole (4b) of the resin sheet (4) and to protrude from one side of the resin sheet (4). Thus, the connector portion (2) and the connector portion (3) are integrated with the resin sheet (4) so as to be free from detachment by means of the fixation structures provided at the through-hole (4a) of the resin sheet (4) and the peripheral portion thereof and the through-hole (4b) of the resin sheet (4) and the peripheral portion thereof, respectively.

Next, an embodiment of the electronic apparatus (9) equipped with the connector sheet (18) of the fifth embodiment will be described. The electronic apparatus (9) has the metal casing (10), which contains at least the connector sheet (18) and the circuit board (8). Like the connector sheet (13), the connector sheet (18) is put over the circuit board (8) so as to cover the circuit elements (11), etc. arranged on the circuit board (8). The circuit board (8) is fixed to the casing (10) by the metal screws (7). There is formed adjacent to the metal screw (7) the ground-connecting portion (12) constituted by the head portion (17a) of the screw (17).

The connector sheet (18) of the fifth embodiment provides the same effects as those of the connector sheet (13) of the second embodiment. Further, the connector sheet (18) provides the following effects.

The connector sheet (18) of this embodiment is configured such that the connector portions (2 and 3) protrude from one side of the resin sheet (4). When the connector portions (2 and 3) are held in a compressed state between the casing (10) and the circuit board (8), the side surfaces of the connector portions (2 and 3) are easily swollen outwards. Thus, the compression load is diminished; and it is possible to diminish the repulsion load applied to the circuit board (8), making it possible to prevent deformation of the circuit board (8).

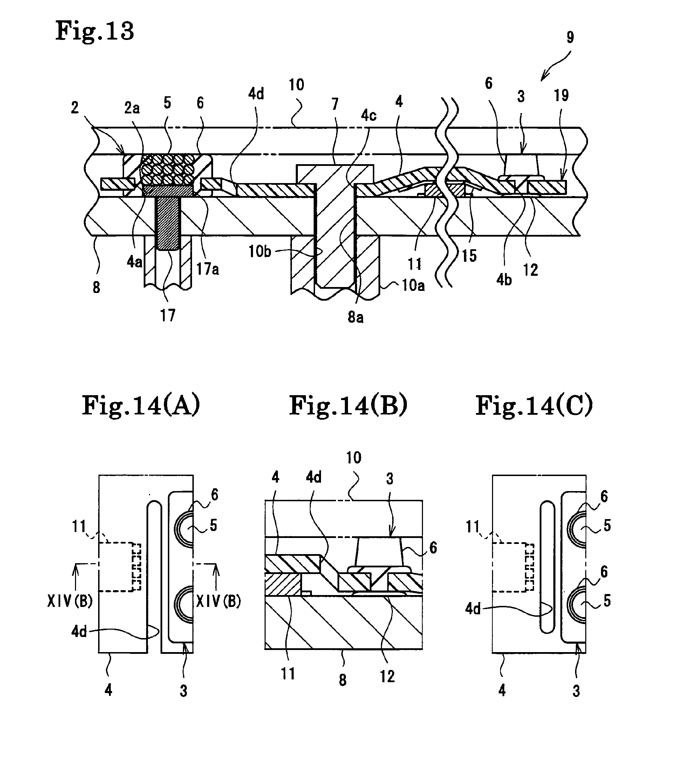

Sixth Embodiment (Figs. 12 and 13): A connector sheet (19) according to a sixth embodiment differs from the connector sheet (14) of the third embodiment in the construction of the first connector portion (2) and the second connector portion (3). Otherwise, this connector sheet is of the same construction and effects as that of the second embodiment.

Like the first connector (2) of the fourth embodiment, the first connector (2) has the engagement recess (2a) adapted to be engaged with and cover the head portion (17a) of the stainless steel screw (17) serving as the "ground-connecting portion" protruding from the board surface of the circuit board (8). The lower end of the conducting portion (5) is exposed at the bottom of the engagement recess (2a), so conduction is effected between the head portion (17a) and the casing (10). The insulating portion (6) is formed in a cylindrical configuration so as to surround the outer periphery of the conducting portion (5) and form the side surface of the engagement recess (2a).

Like the connector portion (3) of the fifth embodiment, the second connector portion (3) of this embodiment is configured so as to, while extending through the resin sheet (4), protrude only from one side thereof. The lower ends of the outer peripheral side surfaces of the insulating portions (6) are engaged with the second through-hole (4b) extending through the resin sheet (4) and the peripheral portion thereof. That is, the second connector portion (3) is formed so as to extend through the through-hole (4b) of the resin sheet (4) and protrude from one side of the resin sheet (4). Thus, the second connector portion (3) is integrated with the resin sheet (4) so as to be free from detachment by the fixation structure formed by the through-hole (4b) of the resin sheet (4) and the peripheral portion thereof.

Next, an embodiment of the electronic apparatus (9) equipped with the connector sheet (19) of the sixth embodiment will be described. The electronic apparatus (9) has the metal casing (10) containing at least the connector sheet (19) and the circuit board (8). Like the connector sheet (14), the connector sheet (19) is put over the circuit board (8) so as to cover the circuit elements (11), etc. arranged on the circuit board (8); the ground-connecting portions (12) made of solder are formed adjacent to the metal screws (7).

The connector sheet (19) of the sixth embodiment provides the same effects as those of the connector sheet (14) of the third embodiment. Further, the connector sheet (19) provides the following effects.

In the connector sheet (19) of this embodiment, its mounting effected such that the engagement recess (2a) of the first connector portion (2) covers the head portion (17a) of the screw (17) in the form of a projection. The engagement with the head portion (17a) of the screw (17) serves as a means for effecting positioning on the connector portion (2), so the mounting of the connector portion (2) is facilitated. Further, it is possible to prevent positional deviation and detachment of the connector (2) and the head portion (17a) of the screw (17), making it possible to maintain a stable ground connection. Thus, the connector sheet is suitable for use in a portable electronic apparatus, which is subject to external forces such as falling impact or contact impact.

The second connector portion (3) is configured so as to protrude from one side of the resin sheet (4). When the connector portion (3) is held in a compressed state between the casing (10) and the circuit board (8), the side surface of the connector portion (3) easily undergoes outward swelling. Thus, the compression load is diminished, and it is possible to diminish the repulsion load of the connector portion (3) applied to the circuit board (8), making it possible to prevent deformation of the circuit board (8).

Modifications common to the embodiments: In the following, modifications common to the connector sheets of the above-mentioned embodiments will be illustrated.

First Modification: While in the above-mentioned embodiments the resin sheet (4) is used as the "sheet portion", it is also possible to use a rubber sheet instead. In this case, the rubber sheet can be formed of a rubber-like elastic material such as silicone rubber, constituting the base material of the connector portions (2 and 3). While it is possible to form the rubber sheet and the connector portions (2 and 3) of different rubber-like elastic material, it is desirable to form them as a single molding using the same material from the viewpoint of a reduction in the number of materials used and a reduction in the number of production steps.

Second Modification: While in the above-mentioned embodiments nothing is provided on the surface of the resin sheet (4) opposed to the casing (10), it is also possible to utilize the wide area of the resin sheet (4). That is, it is possible to stack on that opposing surface a metal layer of aluminum or the like or a graphite layer. By thus providing a metal layer, it is possible to endow the resin sheet (4) with a property by which the resin sheet (4) reflects electromagnetic waves from the outside. By providing a graphite sheet, it is possible to endow the resin sheet (4) with a property by which the resin sheet (4) absorbs electromagnetic waves discharged from the interior of the electronic apparatus (9). Thus, it is possible to realize a connector sheet of high added value.

Third Modification: While in the above-mentioned embodiments the connector portions (2 and 3) are formed of silicone rubber, it is also possible to form the connector portions (2 and 3) of some other rubber-like elastic material having a shock-absorbing property instead. In a connector sheet thus formed, when an impact is applied to the electronic apparatus (9), it is possible to attain, due to the shock-absorbing action of the connector portions (2 and 3), a particularly excellent absorbing performance with respect to an impact conducted from the casing (10) to the circuit board (8). Thus, the connector sheet is suitable for use in a portable electronic apparatus subject to external forces such as a falling impact or a contact impact. In this case, as the rubber-like elastic material having a shock-absorbing property, it is possible to use butyl rubber, urethane rubber, or the like.

Fourth Modification: While in the above-mentioned embodiments the resin sheet (4) covers a part of the circuit board (8), it is also possible for the resin sheet (4) to cover the entire surface of the circuit board (8).

Fifth Modification: While in the first, second, fourth, and fifth embodiments tautness is imparted to the resin sheet (4) by fixing the connector sheet (1, 13, 16, and 18) at two points by means of the metal screws (7), it is also possible to impart tautness to the resin sheet (4) through fixation at three points or more.

Sixth Modification: While in the second through sixth embodiments described above the cutout (4d) is provided between the connector portion (2) and the insertion hole (4c) through which the metal screw (7) is passed, it is also possible, as shown, for example, in Fig. 14(A) through 14(C), to provide a similar cutout (4d) at a position where there is a great difference in height between portions close to each other as in the case of a position between the connector portion (3) and the circuit element (11) adjacent thereto (Figs. 14(A) and 14(B)). Further, while in the above-mentioned examples the cutout (4d) is provided so as to extend from the outer edge into the plane of the resin sheet (4), it is also possible to provide the cutout (4d) in an in-plane position in the resin sheet (4) (Fig. 14(C)).

## Claims

1. A connector sheet (1, 13, 14, 16, 18, 19) for effecting electrical connection between a metal portion (10) constituting a casing (10) of an electronic apparatus (9) and a ground-connecting portion (12, 17) of a circuit board (8) contained in the casing (10), the connector sheet comprising:
an electrically insulating sheet portion (4) mounted to the circuit board (8) so that the electrically insulating sheet portion (4) covers the circuit board (8) which is opposed to the metal portion (10); and
a connector portion (2, 3) which is integrally provided with a conducting portion (5) which is arranged at a position in the sheet portion (4), where the metal portion (10) and the ground-connecting portion (12, 17) are opposed to each other, the conducting portion (5) having one end in contact with the metal portion (10) and another end in contact with the ground-connecting portion (12, 17).

2. A connector sheet (1, 13, 16, 18) according to Claim 1, wherein the sheet portion (4) has a plurality of mounting portions (4c) for fixing the connector sheet to the circuit board (8).

3. A connector sheet (1, 13, 16, 18) according to Claim 2, wherein the connector portion (3) is positioned between at least two mounting portions (4c).

4. A connector sheet (14, 19) according to Claim 1, wherein the sheet portion (4) has at least one mounting portion (4c) for fixing the sheet portion (4) to the circuit board (8) and an adhesive portion (15) glued to the circuit board (8).

5. A connector sheet (16) according to any one of Claims 1 to 4,
wherein the ground-connecting portion (17) of the circuit board (8) is configured to protrude from a board surface, and
wherein the connector portion (2) has an engagement recess (2a) to be engaged with the ground-connecting portion (17).

6. A connector sheet (1, 13, 16, 18) according to any one of Claims 1 to 5, wherein the sheet portion (4) is flexible enough to conform to a change in height of the circuit board (8) according to presence and absence of a circuit element (11).

7. A connector sheet (13, 16, 18) according to any one of Claims 1 to 6, wherein the sheet portion (4) has a cutout portion (4d) allowing the sheet portion (4) to open in a shearing direction in conformity with a change in height of the circuit board (8) according to presence and absence of a circuit element (11).

8. A connector sheet (1, 13, 16) according to any one of Claims 1 to 7, wherein the connector portion (2, 3) is configured to extend through the sheet portion (4) in a thickness direction of the sheet portion (4) and to protrude from both sides thereof.

9. A connector sheet (18) according to any one of Claims 1 to 7, wherein the connector portion (2, 3) is configured to extend through the sheet portion (4) in a thickness direction of the sheet portion (4) and to protrude from one side thereof.

10. A portable electronic apparatus (9), comprising: a casing (10) having a metal portion (10); a circuit board (8) containing the casing (10); and a connector sheet (1, 13, 14, 16, 18, 19) as claimed in one of Claims 1 through 9 effecting electrical connection between the metal portion (10) of the casing (10) and a ground-connecting portion (12, 17) of the circuit board (8).
